(19)

**Europäisches Patentamt**
**European Patent Office**
**Office européen des brevets**

(11) **EP 4 572 121 A1**

(12) **EUROPEAN PATENT APPLICATION**

(43) Date of publication:
**18.06.2025   Bulletin 2025/25**

(21) Application number: **23217308.8**

(22) Date of filing: **15.12.2023**

(51) International Patent Classification (IPC):
**H02M 7/483** (2007.01)      **H02M 1/32** (2007.01)

(52) Cooperative Patent Classification (CPC):
**H02M 7/4835; H02M 1/32; H02M 7/4833**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Rimac Technology LLC**
**10431 Sveta Nedelja (HR)**

(72) Inventor: **Szemberg O'Connor, Teddy**
**London, E3 5EG (GB)**

(74) Representative: **Sonnenberg Harrison**
**Partnerschaft mbB**
**Herzogspitalstraße 10a**
**80331 München (DE)**

(54) **METHOD FOR DIAGNOSTIC ENERGY SHIFTING**

(57)    What is proposed is a method for performing a diagnostic test on a multilevel converter, the method comprising:

selectively switching (S1) at least one first module into series positive or into series negative with at least one second module;

connecting (S2) at least one third module of remaining modules into series positive and/or into series negative and/or in parallel to one another;

charging or discharging (S3) the at least one first module from or to the at least one or more of the remaining modules at a first predefined charge or discharge rate until a first predefined criterion is reached;

when the first predefined criterion is reached, discharging or charging the at least one first module N1 from or to the at least one or more of the remaining modules Nnd at a second predefined discharge or charge rate until a second predefined criterion is reached.

Fig. 2

# EP 4 572 121 A1

**Description**

TECHNICAL FIELD OF THE INVENTION

The present invention relates to a method for diagnostic energy shifting between phases and/or modules of a multilevel converter.

BACKGROUND OF THE INVENTION

The demand for reliable and efficient energy storage solutions has grown significantly with the increasing integration of (renewable) energy sources and the need for grid stability. In this context, the concept of a battery-supplied multilevel converter, has emerged as a promising technology. Such a system combines the benefits of energy storage batteries with the flexibility and functionality of a multilevel converter.

During normal operation, the AC battery operates by switching the energy sources in a dynamically defined schedule to produce an alternating voltage. Thereby, the AC battery is sized such that it may continue normal operation if one energy source or a module comprising multiple energy sources is switched out, i.e., bypassed. This allows the AC battery to continue operation in case of a single energy source or module failure.

Also, concerning AC batteries, maintaining a clear understanding of a health and/or performance of the respective energy sources over time is paramount. To achieve this, a rigorous assessment process is usually employed, involving a series of carefully defined tests conducted at regular intervals throughout a device's lifespan. These evaluations are typically carried out on an annual basis or in a predetermined time interval, providing valuable insights into the device's condition and functionality.

However, the challenge here lies in the fact that these predefined testing conditions seldom occur in the everyday operational parameters of the system. Consequently, the entire AC battery must be temporarily taken offline for the duration of these assessments, resulting in a notable loss of operational time.

In the known prior art documents, the energy discharged during diagnosis is often lost to the grid during the diagnostic test. However, the present application has the advantage of maintaining the energy in the system, such as a multilevel converter, without or with minimal energy loss. This means that the energy discharged from one module and/or phase is used to charge another module and/or phase. Furthermore, one or more of the modules and/or phases can be returned to an operational state in a short notice return time. Returning to the operational state does not require one or more of the modules and/or phases to be charged at 100% of State of Charge and can be switched to the operational state with any State of Charge available.

This necessity underscores the delicate balance between ensuring the AC battery's health and minimizing downtime, and thus, is a critical concern in the realm of electrochemical technology.

SUMMARY OF THE INVENTION

Against this background, it is an object of the present invention to provide an improved method for diagnostic an energy exchange between modules of a multilevel converter.

The object of the present invention is attained by a method of performing a diagnostic test on a multilevel converter having the features of claim 1.

Advantageous embodiments of the present disclosure are the subject matter of the dependent claims.

Linguistically common rephrasing and/or an analogous replacement of respective terms within the scope of common linguistic practice, in particular the use of synonyms backed by the generally recognized linguistic literature, are, of course, comprised by the content of the disclosure at hand without every variation having to be expressly mentioned.

In accordance with a first aspect, a method for performing a diagnostic test on a multilevel converter is provided. The multilevel converter comprises a plurality of modules at least one of which having a preferably predefined State of Charge. The plurality of modules each comprises a plurality of energy sources and a plurality of power converter modules. The method comprising selectively switching at least one first module of the plurality of modules into series positive or into series negative with at least one second module of the plurality of modules; connecting at least one third module of remaining modules of the plurality of modules into series positive and/or into series negative and/or in parallel to one another; charging or discharging the at least one first module from or to the at least one or more of the remaining modules at a first predefined charge or discharge rate until a first predefined criterion is reached, and when the first predefined criterion is reached, discharging or charging the at least one first module from or to the at least one or more of the remaining modules at a second predefined discharge or charge rate until a second predefined criterion is reached.

At least one of the plurality of modules has a predefined State of Charge. It shall be understood that each module can have a different predefined State of Charge, varying from 0% to 100% SOC. It shall be understood that the at least one of the plurality of modules can have a predefined voltage instead of the predefined State of Charge.

Here, "selectively switching at least one first module of the plurality of modules into series positive or into series negative with at least one second module of the plurality of modules" may also refer to preferably selectively switching the at least one of the plurality modules from the non-diagnostic state to a state different from the non-diagnostic state, for example a bypass state or a diagnostic state.

In one non-limiting example, the at least one first module is switched to the diagnostic state, however, the "selectively switching" of the at least first module is not necessarily implied that the at least first module had a different connection configuration with the at least second module of the plurality modules. The at least first module can remain connected with the at least one second module in series positive or into series negative after switching the at least first module to a state different from the non-diagnostic.

By preferably selectively switching the at least one first module into series positive or into series negative with the at least one second module, the at least one or more first modules can be in a state different from the non-diagnostic. This means that several first modules can be, for example, in the diagnostic state which can accelerate the diagnostic test of the entire system of the multilevel converter.

The at least one first module can be connected with one or several second modules into series positive or into series negative to provide a potential difference between the at least one first module and the at least one second module. However, all the remaining modules, i.e., the plurality of modules which are not the at least first module or the at least second module, for example, the at least one third module, can be connected into series positive and/or into series negative and/or in parallel to the at least one another of the remaining modules. It shall be noted that if a number of the remaining modules is one, for example, only one third module, this third module can be connected in parallel with the at least one second module.

One of the mentionable advantages of the claimed method is that the claimed invention provides the possibility of selectively switching the plurality of power converter modules and/or the plurality of energy sources with respect to one another in varying manners. Furthermore, the method enables at least one diagnostic test to be carried out while other power converter modules and/or energy sources remain operational. Thereby, the method precludes the need to disconnect the entire system in order to carry out at least one diagnostic test on a module or energy source level.

In the known prior art, the entire system is disconnected for a long period of time, for example between few hours to few days, to carry out the at least one diagnostic test on a system level. During the diagnostic test, the entire system of the multilevel converter remains inoperative resulting in impossibility to store and/or deliver electrical energy to other devices. In the known prior art documents, the diagnostic period is a long period of time, the diagnostic test in the prior art is performed only when the multilevel converter deficiency is raised, or only periodically with a large interval of time between the diagnostics tests, for example, once per year or per six months.

Disconnecting the entire system of the multilevel converter for the diagnostic test in the prior art documents results in inconvenience of having rare occasions for the multilevel converter diagnostic tests and then the risk of having an undetected multilevel converter deficiency is increased.

In view of the prior art, the claimed method has the advantage that it enables the possibility to keep the multilevel converter in normal operation and at the same time, to perform at least one diagnostics test for at least one of the plurality of power converter modules by switching said at least one first module of the plurality of modules into series positive or into series negative with the at least one second module of the plurality of modules. This possibility is enabled by the AC-topology of the multilevel converter, making it possible to selectively switch the plurality of power converter modules with respect to one another in varying manners.

By preferably periodically subjecting the power converter modules and/or energy sources to diagnostic testing, the method of the present invention helps identify and rectify potential issues early, leading to improved overall reliability and reduced risk of unexpected failures. Furthermore, the method ensures that the multilevel converter operates optimally by monitoring and maintaining the health of its components. This, in turn, leads to consistent and efficient performance. Although the diagnostic testing requires temporary switching of modules in one of a diagnostic state, a non-diagnostic state or a bypass state, the ability to detect and/or address issues promptly can prevent larger, unplanned downtime in the future.

"Energy sources" preferably refer to the individual components or units within the multilevel converter topology that store and/or deliver electrical energy. These energy sources can include batteries, supercapacitors, photovoltaic cells, wind power generators, fuel cells, electric vehicles, chargers with at least one battery storage, flywheels, gravity-based storages, compressed air storages, or any other energy storage devices capable of storing and delivering electrical power.

"Power converter module" preferably refers to a module within the multilevel converter that facilitates the conversion and/or control of electrical power. It includes circuitry, such as switching elements, to manipulate the flow of electrical energy and regulate voltage and current levels.

"Switching element" is configured to selectively switch the at least one first module of the plurality of module into series positive or into series negative with at least one second module of the plurality of modules. "Switching element" preferably refers to electronic devices, such as transistors or thyristors, used within the power converter module to control the flow of electric current. The switching element can be turned on or off selectively to enable or interrupt the current path and facilitate the desired energy transfer or conversion.

Switching into series positive preferably means connecting the at least one power converter module and/or energy source in series with at least one other in a positive configuration, potentially to facilitate the generation of direct current (DC) or alternating current (AC) at the multilevel converter's output.

Switching into series negative preferably means connecting the selected power converter module and/or energy source in series but in a negative configuration, which may also be utilized for DC or AC generation.

Switching in parallel preferably means connecting the selected module and/or energy source in parallel with at least one other power converter module and/or energy source, potentially to influence the output characteristics of the multilevel converter.

Bypass state preferably means switching the selected power converter module and/or energy source to divert it from the normal operational path with respect to at least one other power converter module and/or energy source. This may serve to isolate or protect the module/source or manage load distribution.

Off-State preferably means partly or completely deactivating or shutting down the selected power converter module and/or energy source, thus, removing it from the multilevel converter to conserve energy or perform maintenance. Standby-state preferably means switching the selected power converter module and/or energy source in a standby or low-power mode, preferably ready for quick activation when needed. Another diagnostic state preferably means that the non-diagnostic state may involve transitioning the selected power converter module and/or energy source into another form of diagnostic state or testing, potentially with different parameters and/or objectives than the initial diagnostic state.

By charging or discharging the modules at a predefined charge or discharge rate and monitoring specific criteria, the method improves system performance by identifying any inefficiencies or abnormalities that may be present in the system. The early detection of potential issues may also lead to cost savings in terms of maintenance and repair. Furthermore, a reduction of a system's downtime can be achieved. In particular, with the presented method, a system's shutdown that may otherwise occur after a certain time, for example each year, to test the system against warranty conditions can be avoided. The method allows for the selective switching of power converter modules and energy sources, optimizing the use of available resources based on their condition and performance. This can lead to better resource utilization and potentially extend the lifespan of these components.

It is to be understood, that the first predefined charge or discharge rate is a module-specific rate and can be different for each module in the diagnostic state. For example, the predefined charge rate of the first module is not necessarily equal to the predefined charge rate of the second module. In the same way, the first charge rate may not be the same as a discharge rate of the first module or the second module.

In other words, the at least one first module being under diagnosis can be charged or discharged with a predefined charge or discharge current that may be specifically set for performing the diagnostic test and therefore, is different from a charge or discharge current applied to the remaining modules being in a normal or a non-diagnostic state. The predefined charge or discharge current may be arbitrary and/or steady and/or variable and/or stepwise and/or pulsating.

"Predefined charge or discharge rate" may refer to a specific and/or preestablished speed and/or rate at which the at least one power converter module and/or the at least one energy source is/are charged with electrical energy or discharged of their stored energy. This predefined charge or discharge rate may be set in advance and maintained consistently during the diagnostic test of the multilevel converter. It ensures that the charging or discharging process occurs at a known and controlled pace, allowing for precise monitoring and evaluation. The predefined charge or discharge rate may include an arbitrary and/or steady and/or variable and/or stepwise and/or pulsating charge or discharge rate.

The at least one power converter module and/or the at least one energy source under diagnosis may also be observed without being discharged or charged to collect data of the at least one power converter module and/or the at least one energy source during a rest period and/or before or after charging or discharging the at least one power converter module and/or the at least one energy source.

It is to be noted that data, particularly measurement data, may be collected from the at least one of the plurality of power converter modules and/or the at least one of the plurality of energy sources under diagnosis. Such collected measurement data may preferably be used for testing of the at least one of the plurality of power converter modules and/or the at least one of the plurality of energy sources and/or may be stored. Alternatively or additionally, the collected measurement data may be used to dynamically set end conditions of the diagnostic test and/or for further manual and/or automated analysis. Such analysis, over time, may also affect operating conditions.

The measurement data may be, for example, at least one of a voltage and/or a current and/or a temperature and a combination of them from the at least one first module being in the diagnostic state. These measurement data may be then used to determine health state and/or lifetime information or potential deficiency of the modules.

In one non-limiting example, the at least first of the plurality of modules is in the diagnostic state and being charged from an external energy source or being discharged to an external load. In this scenario, the multilevel converter may be connected or connectable to a grid. In grid connecting, the multilevel converter may be run in a so-called online mode. Only the at least one of the plurality of power converter modules and/or the at least one of the plurality of energy sources being in the diagnostic state may be discharged to the external load or may be charged by the external energy storage or energy providing source. At the same time, the at least another one of the first modules may be connected at least in series positive and/or in series negative with the remaining modules and/or with the at least a further one of the plurality of energy sources and may discharge to the grid or charged by the grid.

The remaining modules can be connected to the least a further one of the plurality of energy sources to generate a direct current and/or a alternating current at the output of the multilevel converter, when the at least one first module is in the diagnostic state.

Specifically, this may be the case in an "offline mode", i.e., when the multilevel converter is not connected to the grid. Thereby, the energy from the at least another one of the plurality of power converter modules and/or the at least another one of the plurality of energy sources being connectable at least in series positive and/or in series negative with the at least a further one of the plurality of power converter modules and/or with the at least a further one of the plurality of energy sources may be charged by or discharged to the external energy storage, i.e., a battery or a BEV, wherein the external energy storage is electrically isolated from the grid. Also, the discharging may be performed to the external load.

In one embodiment, the at least one first module being in a diagnostic state for performing at least one diagnostic test, when the step of charging or discharging the at least one first module from or to the at least one or more of the remaining modules at the first predefined charge or discharge rate until the first predefined criterion is reached.

In a further embodiment, wherein when the second predefined criterion is reached, switching the at least one first module from the diagnostic state to a non-diagnostic state, wherein the at least one first module is connected in parallel with the at least one or more of the remaining modules.

After reaching the second predefined criterion, the at least one first module can be changed from the diagnostic state to the non-diagnostic state or to the bypass state or into operation state or can be shut down, for example, due to a safety issue.

"Predefined criterion" may represent a predefined condition or threshold that may be met or exceeded during the diagnostic state of the multilevel converter. This condition may serve as a critical point of evaluation, indicating when the charging or discharging process has progressed sufficiently for the diagnostic state to conclude. Once this predefined criterion is satisfied, it may trigger the transition of the at least one power converter module and/or the at least one energy source from the diagnostic state to a non-diagnostic state. Also, the predefined criterion may be a period of time after the charge/discharge has finished and the at least one power converter module and/or the at least one energy source has been left in a bypass state to rest the at least one power converter module and/or the at least one energy source for a predetermined time, in particular in order to collect rest data of the at least one power converter module and/or the at least one energy source.

For example, in the case of the switching the at least one first module from the diagnostic state to the non-diagnostic state, when the second predefined criterion is reached, the second predefined criterion can be a predefined value of SOC. For example, when the at least first module is charged or discharged to the predefined value of SOC, then the at least first module is switched to the state, other than diagnostic.

In one non-limiting example, the first predefined criterion and the second predefined criterion are a predetermined temperature and/or a predetermined state of charge (SOC), and/or a predetermined voltage, and/or a predetermined time, and/or a predetermined system control signal, and/or a predetermined current, and/or a predetermined temperature, and/or a predetermined state of energy, and/or a time available to perform the diagnostic test, and/or a predetermined capacity throughput, and/or a predetermined energy throughput and/or a predetermined differential capacity $dQ/dV$, and/or a predetermined voltage over capacity $dV/dQ$, and/or a predetermined voltage over time $dV/dt$, and/or a predetermined current over time $dI/dt$, and/or a predetermined temperature over time $dT/dt$ or a combination of thereof.

"Non-diagnostic state" may refer to the operational mode of the multilevel converter and/or the at least one power converter module and/or the at least one energy source when it is not actively undergoing diagnostic testing or evaluation. In this non-diagnostic state, the multilevel converter and/or the at least one power converter module and/or the at least one energy source may function in its regular operational mode, and it may not actively charge or discharge at the predefined rate or monitoring against predefined criteria. The transition from the diagnostic state to the non-diagnostic state may occur once the predefined criterion has been met, signifying that the testing or evaluation phase has been completed, and normal operation can resume without diagnostic constraints.

It shall be understood that particularly before the predefined criterion is reached, a recharging or discharging of the at least one of the plurality of power converter modules and/or the at least one of the plurality of energy sources may be performed, in case the at least one of the plurality of power converter modules and/or the at least one of the plurality of energy sources has been at least partly and/or at least temporarily discharged in the diagnostic state.

"Diagnostic state" preferably refers to a state of the at least one of the plurality of power converter modules and/or the at least one of the plurality of energy sources in which the respective module(s) and/or energy source(s) may be available for running at least one diagnostic test for providing the measurement data. The measurement data may be used to provide information on a state of at least one of the plurality of power converter modules and/or the at least one of the plurality of energy sources, such as health state and/or lifetime information or potential deficiency of the modules. The output of such the diagnostic test may be a voltage versus capacity curve for the at least one of the plurality of power converter modules and/or the at least one of the plurality of energy sources. The voltage data for the at least one of the plurality of power converter modules and/or the at least one of the plurality of energy sources may be post-processed to produce at least one dQ/dV curve. The peaks of such a dQ/dV curve may be isolated and compared to previous and/or historical test data. A shift may indicate an amount of loss of lithium inventory (LLI) and/or a loss of active material (LAM), in case the energy sources comprise at least one lithium, sodium-ion or any other suitable battery cell.

In a further embodiment, the method further comprises continuing to perform the at least one diagnostic test on the at least one second module, when the second predefined criterion is reached, wherein the second predefined criterion is a time available to perform the at least one diagnostic test.

It shall be understood that before starting the at least one diagnostic test on the multilevel converter, the time available to perform the at least one diagnostic test on the at least one first module may be checked. "The time available" preferably refers to the period of time when the at least one diagnostic module can be disconnected to undergo the diagnostic test. During this period of time, the at least one of the remaining modules from the plurality of modules can be configured to produce an energy to the output of the multilevel converter. The time available can vary from several seconds to several hours or days. When the first diagnostic module is under the diagnostic test, the time available is checked again to perform the at least second diagnostic test on the second module from the plurality of modules. If the time available allows to perform the second diagnostic test, the at least one second module is then switched to the diagnostic state. In view of the available time, the following modules after the second module are switched for the diagnostic state. It should be noted that the first module, the second module and the other modules are not necessarily chosen for the diagnostic test in the serial or consecutive order. The second module and the other modules can be chosen for the diagnostic test based on other criteria as will be explained below.

In the diagnostic state of the at least one of the plurality of power converter modules and/or the at least one of the plurality of energy sources, the power converter modules and/or energy sources not being in the diagnostic state may be configured for producing the alternating current (AC) output to the grid. The at least one of the plurality of power converter modules and/or the at least one of the plurality of energy sources being in the diagnostic state may instead be configured for discharging the direct current output to a direct current-based energy storage, such as a DC-battery, e.g. an EV. This may require a separate current path in/out of the power converter module, which may be achieved via specific switching configuration(s) of the switching elements, which may connect the module and/or energy storage under diagnosis to a DC-energy storage instead of an AC output, such as the grid.

It shall be noted that if the at least one of the plurality of power converter modules and/or the at least one of the plurality of energy sources is back in the non-diagnostic state, the at least one of the plurality of power converter modules and/or the at least one of the plurality of energy sources may be included back into the regular switching schedule of the multilevel converter. If the state of charge (SoC) of the at least one of the plurality of power converter modules and/or the at least one of the plurality of energy sources permits, the at least one of the plurality of power converter modules and/or the at least one of the plurality of energy sources may resume providing the alternating current.

Also, particularly if the multilevel converter may not be connected to the grid, thus being run in an offline mode, another one of the at least one of the plurality of power converter modules and/or another one of the at least one of the plurality of energy sources may charge or discharge the at least one of the plurality of power converter modules and/or the at least one of the plurality of energy sources that were in the diagnostic state to rebalance the SOC. Furthermore, it shall be noted that the at least one of the plurality of power converter modules and/or the at least one of the plurality of energy sources that exists from the diagnostic mode may be charged, in particular in a direct current (DC) mode, from an external power source, e.g. a solar panel, a fuel cell, a battery electric vehicle (BEV), and/or any other suitable DC source. It shall be understood that such a DC charging may include use of a further DC/DC converter.

It may be preferable if a scheduler or a controller of the multilevel converter controls and/or schedules and/or issues discharging the electrical energy of the at least one of the plurality of power converter modules and/or the at least one of the plurality of energy sources to the plurality of other power converter modules and/or multiple other energy sources, for example, to level energy between different power converter modules and/or energy sources.

In a further embodiment, the method further comprises selectively switching the at least one second module of the plurality of modules from a non-diagnostic state to the diagnostic state and connecting the at least one second module into series positive or into series negative with at least one fourth module of the plurality of modules, wherein the at least one or more of the remaining modules of the plurality of modules are connected into series positive and/or into series negative and/or in parallel to one another.

In this embodiment, the at least one second module is in the diagnostic state and is connected with the at least one fourth module for generating the potential difference between the at least one second module and the at least one fourth module, relative to the remaining non-diagnostic modules.

It should be noted that in one non-limiting example, the fourth module may also be the at least one first module used before for performing the first diagnostic test or may also be the at least one third module which was connected into series positive and/or into series negative and/or in parallel to other remaining modules during the first diagnostic test. It shall be understood that this example applies to the system with the at least four modules, however in another non-limiting example with only three modules in the system, the fourth module is the first module used before for performing the first diagnostic test.

In a further embodiment, the State of Charge (SOC) of the at least one first module is increased during the charging of the at least one first module or the State of Charge (SOC) of the at least one first module is decreased during the discharging of the at least one first module, the increase or the decrease of the SOC of the at least one first module is equal to a difference between a maximum value of SOC and an initial value of SOC of the at least one first module, wherein the maximum value of SOC is in the range from 0 to 100.

In one non-limiting example of this embodiment, the maximum value of SOC is for example 100 and the initial value of SOC of the at least one first module before performing the diagnostic test is 40. Therefore, the decrease of the SOC of the at least one first module is equal to 60.

In a further embodiment, the State of Charge (SOC) of the at least one or more of the remaining modules is decreased or increased during the charging or discharging of the at least one first module, wherein the decrease or increase of the SOC of the at least one or more of the remaining modules is equal to the increase or decrease of the SOC of the at least one first module divided by a number of the at least one or more of the remaining modules.

In a further embodiment, the capacity of the at least one or more of the remaining modules is decreased or increased during the charging or discharging of the at least one first module, wherein the decrease or increase of the capacity of the at least one or more of the remaining modules is equal to the increase or decrease of the capacity of the at least one first module divided by a number of the at least one or more of the remaining modules.

In the current embodiment, the increase or decrease of the SOC of the at least one first module is not necessarily divided by all the remaining modules but only on the remaining modules which are in the non-diagnostic state. Some of the remaining modules can be in the bypass state or disconnected from the entire system.

In a further embodiment, the State of Charge (SOC) of the at least one first module is decreased or increased during the discharging or charging of the at least one first module, the decrease or the increase of the SOC of the at least one first module is equal to a delta SOC divided by the number of the at least one or more of the remaining modules, wherein the delta SOC is a difference between the maximum value of SOC and a minimum value of SOC, wherein the minimum value of SOC is in the range from 0 to 100.

In a further embodiment, the respective State of Charge (SOC) of the at least one or more of the remaining modules is increased or decreased during the discharging or charging of the at least one first module, the increase or decrease of the respective SOC of the at least one or more of the remaining modules is equal to the decrease or increase of the respective SOC of the at least one first module multiplied by a number of two and divided by a subtraction between the number of at least one or more of the remaining modules and a number of two and by a subtraction between the number of at least one or more of the remaining modules and a number of 1.

In a further embodiment, the respective capacity of the at least one or more of the remaining modules is increased or decreased during the discharging or charging of the at least one first module, the increase or decrease of the respective capacity of the at least one or more of the remaining modules is equal to the decrease or increase of the respective capacity of the at least one first module multiplied by a number of two and divided by a subtraction between the number of at least one or more of the remaining modules and a number of two and by a subtraction between the number of at least one or more of the remaining modules and a number of 1.

In a further embodiment, the method further comprising generating a first potential difference between the at least one first module and the at least one or more of the remaining modules by switching the at least one first module into series positive or series negative with respect to the at least one or more of the remaining modules being switched into series negative or series positive with one another, or further comprising generating the first potential difference between the at least one first module and the at least one or more of the remaining modules by, preferably alternately, switching the at least one first module into series positive or into series negative with the at least one second module of the plurality of modules, wherein the at least one or more of the remaining modules are switched into series negative or into series positive or into parallel.

In a further embodiment, a sum of potential differences between the at least one second module and the at least one or more of the remaining modules is higher than the first potential difference.

In one non-limiting example of the present application, when the at least one first module does not have a sufficient potential difference, the at least one first module may be connected with the at least one of the remaining modules being in the non-diagnostic state if the sum of potential differences between the at least one second module and the at least one or more of the remaining modules is higher than the first potential difference.

It shall be understood that the remaining modules can be switched in series negative with the at least one first module or in series positive or into parallel with respect to the remaining modules.

In a further embodiment, during the charge or the discharge of the at least one first module, the at least one or more of the remaining modules are connected in parallel to one another.

In a further embodiment, the method further comprises measuring by at least one measurement unit at least a voltage and/or a current and/or a temperature of the at least one first module, when the at least one first module is charged or discharged.

There may be more than one measurement sensor and/or measurement unit present in the multilevel converter. Such measurement sensors and/or measurement units may be configured for current and/or temperature measurements. The multilevel converter may be equipped with multiple sensors for supervising the module and/or energy source under diagnosis and/or the remaining energy sources.

In a further embodiment, the method further comprises determining by the at least one measurement unit a differential capacity, dQ/dV, of the at least one first module, based on at least the measured voltage of the at least one first module, or, wherein a time pulse and/or a C-Rate for charging or discharging of the at least one first module is different from a further time pulse and/or a further C-Rate for charging or discharging of the at least one second module.

"Time pulse" may be understood as a parameter for charging or discharging the at least one of the plurality of power converter modules and/or the at least one of the plurality of energy sources. The time pulse may be a measure of time duration used in controlling the charging and/or discharging.

"C-Rate" may be understood as a parameter for charging or discharging the at least one of the plurality of power converter modules and/or the at least one of the plurality of energy sources. In battery technology, the C-Rate is a measure of charge and discharge rates relative to the battery's capacity. It indicates how quickly or slowly a battery is charged or discharged.

In other words, the mentioned parameters (time pulse and/or C-Rate) used for charging or discharging the at least one of the plurality of power converter modules and/or the at least one of the plurality of energy sources in the diagnostic state are "different from a further time pulse and/or a further C-Rate for charging or discharging of the at least another one of the plurality of power converter modules and/or the at least another one of the plurality of energy sources." This means that different components within the multilevel converter may be subject to different time pulses and/or C-Rates during the diagnostic state.

In a further embodiment, the at least one first module is selected for performing the at least one diagnostic test based on a third predefined criterion, wherein the third predefined criterion is at least one of a position of the at least one first module among the plurality of the modules, a potential issue raised by a software controller, or an alert message from the software controller indicating an end-of warranty term of the at least one first module.

In a further embodiment, wherein the multilevel converter comprises at least two electrical phases, a first electric phase comprising the at least one of the plurality of power converter modules and/or the at least one of the plurality of energy sources and a second electric phase comprising at least another one of the plurality of power converter modules and/or at least another one of the plurality of energy sources, wherein the method further comprising: charging or discharging the electrical energy stored in the at least one of the plurality of power converter modules and/or in the at least one of the plurality of energy sources of the first phase from or to the at least another one of the plurality of power converter modules and/or to the at least another one of the plurality of energy sources of the second phase.

The multilevel converter comprises at least two "electrical phases". These two electrical phases may represent distinct parts and/or sections of the multilevel converter. The first phase may include certain "power converter modules" and/or "energy sources," while the second phase may include different "power converter modules" and/or "energy sources". The two phases may be connectable to respective phases of the power grid. The multilevel converter may comprise more than two phases. Particularly, the multilevel converter may comprise three or more phases. The phases may be connectable to a common star point and/or a delta connection. During the diagnostic state, there may be an action of "charging or discharging the electrical energy" that is stored in the "power converter modules" and/or "energy sources" of the first phase from or to at least one "power converter module" and/or at least one "energy source" of the second phase. Thus, energy transfer between phases may be possible according to this embodiment. Said discharged energy may thus be directed and/or transferred to the "power converter modules" and/or "energy sources" of the second phase.

In a further embodiment, the method further comprises controlling an effective current by a pulse width modulation controller on each of the plurality of modules such that the time pulse and/or the C-Rate for charging or discharging of the at least one first module remains unchanged or varied as required by a diagnostic test, in particular, by applying a series of pulses or the like.

It shall be understood that the pulse width modulation controller is the programmed multilevel controller adapted to control the effective current of the plurality of modules. As it has been mentioned before, to induce a discharge from, for example, the plurality of remaining modules, the potential difference has to be generated between the plurality of the remaining modules and the at least one first module. In one non-limiting example, the remaining modules or the at least first modules may control the effective current using the pulse width modulation controller. The plurality of modules has no resistive load between the plurality of modules, therefore the pulse width modulation controller allows to avoid a current spike and extremely high current due to the low resistance path. The current spikes and the extremely high current can damage the modules of the multilevel controller and the other electronics components.

In a further embodiment, wherein the first predefined criterion and the second predefined criterion are the respective State of the Charge (SOC), wherein the first and second predefined criteria are in the range from 0 to 100, preferably in the range from 10 to 90 SOC.

There may be more than one predefined criterion or thresholds. There may be predefined criteria having different weights. The predefined criteria may be used as a criterion to initiate the diagnostic state. Thus, the at least one predefined criterion may be used as a trigger to switch the respective power converter module and/or energy source in the diagnostic state.

In one non-limiting example, different criteria have different weights or importance to initiate and end the diagnostic state. In this non-limiting example, more important weight is given in a decreasing order firstly to SOC limit, voltage limit, time limit, temperature limit, current limit, and lastly to memory limit of the diagnostic module. However, other weights and "weight" order can be used as well.

In one non-limiting example, when the first predefined criterion is reached, a time break is provided before the discharging or charging of the at least one first module at the second predefined discharge or charge rate, wherein the time break is in the range from 1 second to 10 hours, preferably, in the range from 10 second to 6 hours.

In a further embodiment, the method further comprises rebalancing of the SOC of the plurality of modules, wherein the at least one first module is connected into series negative and the at least one or more of the remaining modules are connected into series positive and/or into series negative and/or in parallel to one another.

The rebalancing of the SOC or the charge rebalancing refers to a process of equalizing or adjusting the charge levels of the plurality of power converter modules and/or the plurality of energy sources. This rebalancing and/or leveling of energy between the power converter module and/or the energy source, after having been diagnosed, may be controlled by a controller or scheduler of the multilevel converter. The rebalancing and/or leveling may be performed until the power converter module and/or the energy source, having been diagnosed, may have the same energy as its neighboring and/or adjacent power converter modules and/or the energy sources.

In a further embodiment, the SOC of the at least one first module after the charge is a sum of the respective SOCs of the remaining modules, wherein, after charging, the SOC of the at least one first module is lower than or equal to 100%.

In a further embodiment, a minimum value of SOC of the at least one first module before charging is equal to or higher than a sum of differences between a value of 100% of SOC and an initial SOC of each of the remaining modules before charging of the at least one first module.

In a further embodiment, a minimum value of SOC of the at least one first module before discharging is equal to or higher than an initial SOC of the at least one first module, where the initial SOC is a value of SOC before starting the diagnostic test.

In a further embodiment, the rebalancing of the SOC of the plurality of modules comprises charging or discharging the at least one first module to a first final SOC, wherein the first final SOC is a difference between a maximum SOC and a minimum SOC divided by a number of the remaining modules.

In a further embodiment, the rebalancing of the SOC of the plurality of modules comprises charging or discharging the at least one of the remaining modules to a second final value of SOC, wherein the second final value of SOC is equal to the first final value of SOC multiplied by a sum of a number of the at least one first modules and a number 1, divided by a subtraction of a number of the remaining modules and a number 1.

All aspects and embodiments as described above may be combined as deemed fit by the skilled person.

"A(n)" in the present case should not necessarily be understood to be restrictive to exactly one element. Rather, a plurality of elements, such as, for example, two, three or more, can also be provided. Any other numeral used here, too, should not be understood to the effect that there is a restriction to exactly the stated number of elements. Rather, numerical deviations upwards and downwards are possible, unless indicated to the contrary.

Further possible implementations of the invention also comprise not explicitly mentioned combinations of any features or embodiments that are described above or below with respect to the exemplary embodiments. In this case, a person skilled in the art will also add individual aspects as improvements or supplementations to the respective basic form of the invention.

DESCRIPTION OF THE FIGURES

Fig. 1 shows a flowchart of a method for performing a diagnostic test on a multilevel converter according to an embodiment of the present invention;

Fig. 2 shows a refinement of a multilevel converter being configured for grid connection; and

Fig. 3 shows a further schematic refinement of a multilevel converter having a first topology.

DETAILED DESCRIPTION OF THE INVENTION

Unless indicated to the contrary, elements that are the same or functionally the same have been given the same reference signs in the figures. It should also be noted that the illustrations in the figures are not necessarily true to scale.

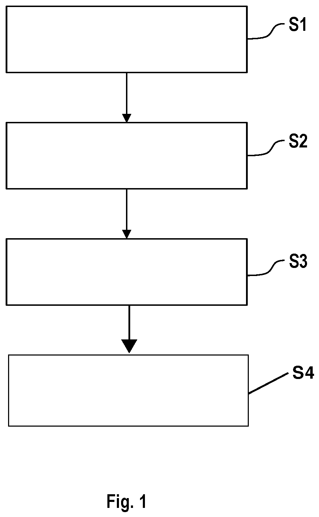

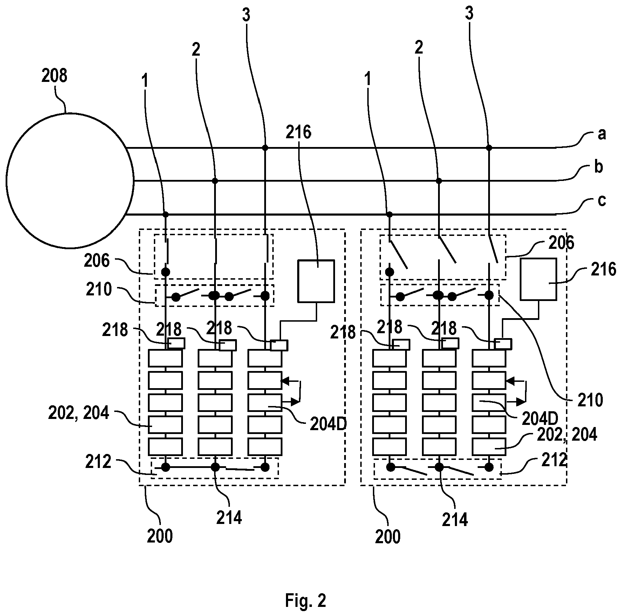

Fig. 1 shows a flowchart of a method for diagnostic energy shifting between phases and/or modules of a multilevel converter according to an embodiment of the present invention. A method for controlling a multilevel converter 200 comprising a plurality of modules N. The plurality of modules N each comprises a plurality of energy sources 2600 and a plurality of power converter modules 204. Each power converter module 204 comprising at least two switching elements 2800 (see Figs. 2 to 3). At least one of the plurality of modules N has a preferably predefined State of Charge (SOC).

The method comprises in a step S1, selectively switching at least one first module N1 of the plurality of modules N into series positive or into series negative with at least one second module N2 of the plurality of modules N.

The method comprises in a step S2, connecting at least one third module N3 of remaining modules Nnd of the plurality of modules N into series positive and/or into series negative and/or in parallel to one another of the remaining modules.

The method comprises in a step S3, charging or discharging the at least one first module N1 from or to the at least one or more of the remaining modules Nnd at a first predefined charge or discharge rate until a first predefined criterion is reached.

The method comprises in a step S4, when the first predefined criterion is reached, discharging or charging the at least one first module N1 from or to the at least one or more of the remaining modules Nnd at a second predefined discharge or charge rate until a second predefined criterion is reached.

Fig. 2 shows a refinement of the multilevel converter 200 being configured for grid connection. In Fig. 2, for example, two multilevel converters 200 are shown, both comprising the same or a similar topology. The respective multilevel converter 200 comprises in this example three phases, each of which comprises five power converter modules 204 as well as respective energy sources 2600. The three phases of each multilevel converter 200 are indicated by numbering 1, 2, 3, respectively. The respective multilevel converter 200 comprises, preferably phase-individual, grid terminal connectors 206 arranged on each phase 1, 2, 3.

The respective grid terminal connector 206 may be configured to connect the respective phase 1, 2, 3 of the respective multilevel converter 200 to a corresponding, respective grid phase a, b, c of a power grid 208. The grid terminal connectors 206 may be contactors or another kind of switch elements. The respective multilevel converter 200 may comprise interphase connectors 210 on a grid-connecting side of the respective multilevel converter 200, the interphase connectors 210 being preferably arranged between phase 1 and 2, as well as between phase 2 and 3. Of course, in other refinements, the interphase connectors 210 may also be arranged between phase 1 and 3.

The interphase connectors 210 may be contactors or another kind of switch elements. The interphase connectors 210 may be configured to connect phases 1 and 2 and/or phases 2 and 3 with one another. Also, the respective multilevel converter 200 may comprise common star point connectors 212. The star point connectors 212 may be arranged on a common star point 214 side of the respective multilevel converter 200, the star point connectors 212 being preferably arranged between phase 1 and 2, as well as between phase 2 and 3.

The star point connectors 212 may be configured to connect the three phases 1, 2, 3 to the common star point 214. In such a case, the interphase connectors 210 preferably remain open. By selectively closing the interphase connectors 210 and/or the star point connectors 212, at least two of the three phases 1, 2, 3 may be connectable at least temporarily in series (positive and/or negative) and/or in parallel with one another. The left-handed multilevel converter 200 is shown in a grid connection, thus with closed grid connectors 206.

Furthermore, the left-handed multilevel converter 200 is shown with closed star point connectors. The right-handed multilevel converter 200 is shown without grid connection, thus with opened grid connectors 206. Furthermore, the right-handed multilevel converter 200 is shown with opened star point connectors. Both multilevel converters 200 are shown with opened interphase connectors.

Also, according to Fig. 2, for each multilevel converter 200 a power converter module 204 being in the diagnostic state is shown and indicated by 204D. According to the invention, an energy transfer between the power converter module under diagnosis 204D and a neighboring power converter module 204 is possible and indicated by respective arrows.

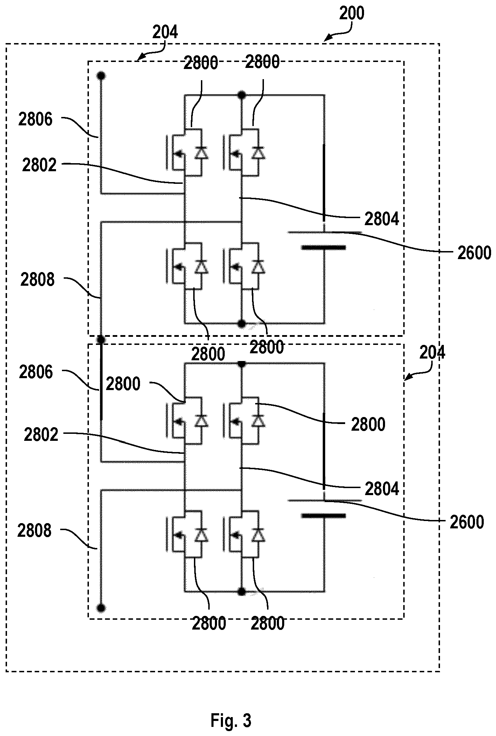

Fig. 3 shows a schematic refinement of a multilevel converter 200 having an exemplary topology. It is to be specifically mentioned that this is only one possible configuration. There are multiple other topologies of a multilevel converter 200 that can be used. Particularly, Fig. 3 shows a potential switching setup for the multilevel converter 200. The multilevel converter 200 exemplarily comprises at least two power converter modules 204 that may be similar to those shown in Fig. 2. Also, the multilevel converter 200 further comprising at least two energy sources 2600, wherein at least one of the energy sources 2600 is comprised in each of the power converter modules 204. Each of the at least two energy sources 2600 comprises at least one battery cell and/or at least one capacitor and/or at least one photovoltaic panel. The power converter module 204 being configured to selectively switch the at least one energy source 2600 of the respective module with respect to the other energy source 2600 at least temporarily in series positive or in series negative or in parallel to generate a controllable alternating or direct current at the output of the multilevel converter 200. The power converter module 204 exemplarily includes four switching elements 2800. In other topologies, a different number of switching elements 2800 may be used. Two respective switching elements 2800 are provided per module string 2802, 2804 of the exemplary multilevel converter 200 in series connection. Between each of the two switching elements 2800 per string 2802, 2804 a respective further terminal connection 2806, 2808 is provided. The terminal connections 2806, 2808 may be used to modularly connect multiple power converter modules 204 and/or respective modules and/or respective multilevel converters 200 together.

In the first aspect of the invention, only one the first module N1 is in the diagnostic state. In this aspect of the invention, the at least second module N2 is connected into series positive or into series negative with the first module N1 to produce a sufficient potential difference to drive the current. In the second aspect of the invention, the at least two first modules from the plurality of modules N are in the diagnostic state simultaneously. In this aspect of the invention, the at least two first modules N1 are in the diagnostic state that can generate a sufficient potential difference. Then the remaining modules Nnd are connected in N into series positive and/or into series negative and/or in parallel to one another. The remaining modules Nnd are the remaining modules from the plurality of modules N after the connection of the first module N1 with the second module N2.

In the first aspect of the invention, the remaining modules Nnd remain available to produce the AC power to the grid, if required. The first module N1 is selected for performing the at least one diagnostic test based on a third predefined criterion, wherein the third predefined criterion is at least one of a position of the at least one first module N1 among the plurality of the modules N, a potential issue raised by a software controller, or an alert message from the software controller indicating an end-of warranty term of the at least one first module N1. The first module N1 is selected as the diagnostic modules, indicated by the superscript in the equations "diag".

The predefined State of Charge (SOC) at which the diagnostic test starts on the first module N1 is $SOC_{start}^{diag}$. The predefined State of Charge (SOC) is selected based on a combination of the test required, and/or the time available. Each module under the diagnostic test may have a different predefined State of Charge (SOC). The increase of SOC during the charge of the first module N1 is calculated as follows:

$$\Delta SOC_{t=0}^{diag} = SOC_{diagstart}^{diag} - SOC_{t=0}^{diag}$$

Wherein $SOC_{t=0}^{diag}$ is an initial value of SOC of the first module N1 at the time t=0 before starting the first diagnostic test and $SOC_{start}^{diag}$ is a starting value of SOC. The maximum value SOC of the first module N1 that can be reached during the charge of the first module N1 (e.g., diagnostic module) is no higher than the sum of the SOCs of the remaining modules Nnd (e.g., non-diagnostic modules). The maximum value of SOC is in the range from 0 to 100%. During the discharge of the first module N1 under the diagnostic test, the minimum value of SOC of the first module N1 is equal or higher than the initial value of SOC of the first module N1.

The first module N1 is connected in series positive or in series negative with the second module N2. The first module N1 may be connected to one or more second modules N2. For example, if the output energy, output voltage or output power that is required to be output from the system (i.e., a multilevel converter) is generated by at least N-1 modules, then only one second module can be connected in series positive or in series negative during the discharge of the energy from the system. In this case, the difference between the SOC values of the remaining modules needs to be minimized.

In the case, when less then N-1 modules are necessary to generate the energy and/or the voltage and/or power from the system, then, more than one second module N2 can be connected with the first module N1 in series positive or in series negative.

The first module N1 in the first step of the method can be charged or discharged. In case of discharging of the first module N1, the minimum SOC is equal to or higher than a sum of differences between a value of 100% of SOC and an initial SOC of each of the remaining modules Nnd before charging of the first module N1.

At the end of the diagnostic test, the charge from the first module N1 is discharged to the remaining modules Nnd. The final value of SOC at the end of the diagnostic test, $SOC_{diagend}^{diag}$, is equal to or higher than a critical value of SOC. The critical value of SOC is a minimum possible value of SOC of the first module N1, that, after the discharge of the first module N1 to the remaining modules Nnd, will charge all of the remaining modules to the value of 100% of SOC. For this reason, the final value of SOC at the end of the diagnostic test has to be equal or higher than the minimum possible value of SOC of the first module N1 (critical value of SOC).

During the charge or discharge of the first module N1, N - N1 modules (also named remaining modules) are connected into series positive or into series negative or in parallel with one another of the remaining modules Nnd. The at least two modules from the remaining modules Nnd are connected in parallel with each other to generate a sufficient potential difference with the diagnostic module.

In one non-limiting example, all the remaining modules are connected in parallel with respect to one another. This configuration with parallel connections results in the smallest SOC change between non-diagnostic modules (the remaining modules Nnd). Assuming all modules have the same nominal capacity (in Ah), the SOC decrease of each of the remaining modules Nnd is defined as follows:

$$\Delta \text{SOC}_{t=0}^{j} = \frac{\left( SOC_{diag\ start}^{diag} - SOC_{t=0}^{diag} \right)}{N-1}$$

Where $SOC_{diag\ start}^{diag}$ is the starting SOC of the diagnostic module, $SOC_{t=0}^{diag}$ is the initial SOC of the diagnostic module at time t = 0. If the nominal capacity of the modules are not equal, then the SOC scale is unique for each module, and the equation is

$$\Delta Capacity_{t=0}^{j} = \frac{\left( Capacity_{diag\ start}^{diag} - Capacity_{t=0}^{diag} \right)}{N-1}$$

Capacity can be converted to SOC via

$$SOC = \frac{capacity_t}{nominal\ capacity} \times 100\%$$

for each module, where the nominal capacity is a reference value. A pulse width modulation controller is configured to control the current of all of the plurality of modules N. It shall be noted that, of course, each module can be individually controlled. The pulse width modulation controller controls an effective current such that a time pulse and/or the C-rate for charging or discharging of the first module N1 remains unchanged or varied as required by a diagnostic test, in particular, by applying a series of pulses or the like.

The time pulse may be a measure of time duration used in controlling the charging and/or discharging. "C-Rate" may be understood as a parameter for charging or discharging the at least one of the plurality of power converter modules and/or the at least one of the plurality of energy sources.

The value of the SOC indicated by t = 1 of each remaining module Nnd after the charge of the first module N1 is determined by the following equation, assuming all modules have equal nominal capacity:

$$SOC_{t=1}^{j} = SOC_{t=0}^{j} + \Delta SOC_{t=0}^{j}$$

It shall be noted that the value of the SOC of the remaining modules Nnd, $SOC_{t=0}^{j}$, can be unique for each j = 1.. N - 1 and does not have to be equal to the value of the SOC of the first module N1, $SOC_{t=0}^{diag}$, where a superscript j is indicated to the remaining modules Nnd. If modules have unequal nominal capacity, the equation is

$$Capacity_{t=1}^{j} = Capacity_{t=0}^{j} + \Delta Capacity_{t=0}^{j}$$

After charging of the first module N1 and collecting the measurement data during the charge of the first module N1, the first module N1 starts the diagnostic discharge. The remaining modules Nnd are reconfigured into series positive and/or into series negative and/or in parallel to one another to minimize the imbalance among the remaining modules Nnd. In one example, the first module N1 and the second module N2, (i = 1) are connected in series negative or in series positive. In one non-limiting example, the remaining modules Nnd (j = 1.. N - 1, j\neqi) are connected in parallel with each other. The decrease of the SOC value in the first module N1 is equal to:

$$SOC_{t=2}^{diag} = SOC_{t=1}^{diag} - \frac{\left(SOC_{diag\,start}^{diag} - SOC_{diag\,stop}^{diag}\right)}{N-1}$$

Assuming modules N1 and N2 have the same nominal capacity, the decrease of the SOC value in the second module N2 connected in series negative or in series positive to the first module Nnd (t=1 in the following equation) is equal to:

$$SOC_{t=2}^{j=i} = SOC_{t=1}^{j=i} - \frac{\left(SOC_{diag\,start}^{diag} - SOC_{diag\,stop}^{diag}\right)}{N-1}$$

If nominal capacities of N1 and N2 are not equal, the equation is:

$$Capacity_{t=2}^{j=i} = Capacity_{t=1}^{j=i} - \frac{\left(Capacity_{diag\,start}^{diag} - Capacity_{diag\,stop}^{diag}\right)}{N-1}$$

For modules with equal nominal capacity, the SOC increase in the remaining modules, j = 1.. N - 1, j # i , is equal to:

$$SOC_{t=2}^{j} = SOC_{t=1}^{j} + \frac{\left(SOC_{diag\,start}^{diag} - SOC_{diag\,stop}^{diag}\right)}{N-1}\frac{2}{N-2}$$

For modules with unequal nominal capacity, the equation is

$$Capacity_{t=2}^{j} = Capacity_{t=1}^{j} + \frac{\left(Capacity_{diag\,start}^{diag} - Capacity_{diag\,stop}^{diag}\right)}{N-1}\frac{2}{N-2}$$

When the second predefined criterion is reached, the at least one first module N1 is switched from the diagnostic state to a non-diagnostic state. The at least one first module N1 is then connected in parallel with the at least one or more of the remaining modules, for example the second module N2. The method further continues performing the at least one diagnostic test on the one second module N2.

The last module from the plurality of modules N is in the diagnostic state when i = N - 1. The diagnostic test is stopped when the value of SOC of the last module *i = N* - 1 after the discharge is equal to the stop value of the SOC. $SOC_{t=N-1}^{diag} = SOC_{diag\,stop}^{diag}$. This means that at a required value of the SOC (stop value), the discharge will be stopped, and the diagnostic test will be stopped for the entire system. After stopping of the diagnostic test, a time break may be provided. The time break is provided before the discharging or charging of the at least one first module N1 at the second predefined discharge or charge rate, wherein the time break is in the range from 1 second to 10 hours, preferably, in the range from 10 second to 6 hours.

The method further comprises a step of rebalancing of the SOC of the plurality of modules N, wherein the first module N1 is connected into series negative and the at least one or more of the remaining modules Nnd are connected into series positive and/or into series negative and/or in parallel to one another.

In one non-limiting example, during the rebalancing of the SOC, the first module N1 is switched into series negative and the remaining modules Nnd are connected into series negative or in series positive or in parallel with each other. The increase of the value of SOC of the first module N1 is determined by:

$$\Delta SOC_{t=N} = SOC_{end}^{diag} - SOC_{t=N-1}^{diag}$$

If all modules have equal nominal capacity and are preferably at the same SOC, the decrease of the value of SOC from each of the remaining modules Nnd is determined by:

$$\Delta SOC_{t=N} = \frac{SOC_{end}^{diag} - SOC_{t=N-1}^{diag}}{N-1}$$

For modules with unequal nominal capacity, the equation is:

$$\Delta Capacity_{t=N} = \frac{Capacity_{end}^{diag} - Capacity_{t=N-1}^{diag}}{N-1}$$

It shall be noted that at the end of the diagnostic test, the SOC values of the remaining modules are not necessarily equal. After completing the diagnostic test on the at least one of the first modules N1, the system can be reconnected to the grid, or be used for any other function, such as further diagnostics tests, connected to energy generation sources or can be left inactive.

In the second aspect of the invention, more than one first module N1 from the plurality of modules N can be in diagnosis state simultaneously. Typically, in the second aspect of the invention, there is no requirement for a short notice return of the multilevel converter to produce or receive the AC power to/from the grid. In this case, the energy is only exchanged between modules within one phase 1, 2, 3. However, the modules across phases 1, 2, 3 could be connected as both diagnostic or non-diagnostic modules.

Diagnostic modules (i.e., first module N1) can be selected for performing the at least one diagnostic test based on a third predefined criterion. The third predefined criterion is at least one of a position of the at least one first module among the plurality of the modules, a potential issue raised by a software controller, or an alert message from the software controller indicating an end-of warranty term of the at least one first module. There are at least two diagnostic modules N1 indicated by superscript i in the equations. In one non-limiting example, each first module N1 being in the diagnostic state can have its own diagnostic-start SOC value.

The at least two first modules N1 are undergoing the diagnostic test. It should be understood that the same equations apply for the charge or the discharge of the at least two first modules N1.

The at least two first modules N1 are connected into series positive and/or into series negative and/or in parallel to one another. The SOC added to the at least two first modules N1 is determined by:

$$\Delta SOC_{t=0}^{i} = SOC_{diag\ start}^{i} - SOC_{t=0}^{i}$$

The remaining modules Nnd are connected into series positive and/or into series negative and/or in parallel to one another such that the potential difference of the remaining modules Nnd is higher than the potential difference of the at least two first modules N1. Assuming the remaining modules have equal nominal capacity, the SOC lost from each of the remaining modules is:

$$\Delta SOC_{t=0}^{j} = -\frac{\sum_{j,j\neq i}^{N_d}\left(SOC_{diag\ start}^{j} - SOC_{t=0}^{j}\right)}{N-N_d}$$

If the nominal capacity is not equal, the equation is:

$$\Delta Capacity_{t=0}^{j} = -\frac{\sum_{j,j\neq i}^{N_d}\left(Capacity_{diag\ start}^{j} - Capacity_{t=0}^{j}\right)}{N-N_d}$$

Which can be converted to the SOC scale for each module as described previously.

Step 3 - Diagnostic discharge

The at least two first modules N1 are connected into series positive and/or into series negative and/or in parallel to one another such that the combined potential difference of the first modules N1 is larger than that of the remaining modules Nnd. In one example, a time break may be provided between the preparatory charging step and the start of the diagnostic discharge. The discharge of the SOC lost from each the at least two first modules N1 during the diagnostic discharge is equal to:

$$\Delta SOC_{t=1}^i = SOC_{diag\ stop}^i - SOC_{diag\ start}^i$$

If the remaining modules have equal nominal capacity the capacity gained by the remaining modules Nnd is indicated by a delta SOC, calculated as follows:

$$\Delta SOC_{t=1}^j = \frac{\sum_{j,j\neq i}^{N_d}\left(SOC_{diag\ start}^j - SOC_{diag\ stop}^j\right)}{N - N_d}$$

If the remaining modules do not have equal nominal capacity, the equal is:

$$\Delta Capacity_{t=1}^j = \frac{\sum_{j,j\neq i}^{N_d}\left(Capacity_{diag\ start}^j - Capacity_{diag\ stop}^j\right)}{N - N_d}$$

Similarly to the first aspect of the invention, one of the final steps of the method is to rebalance all the modules N to the end value of SOC. The end value of SOC is not necessarily equal to the initial SOC value at t = 0. The SOC value added to the at least two first modules N1, whose location in the system are indicated by *i*, is:

$$\Delta SOC_{t=2}^i = SOC_{end}^i - SOC_{diag\ stop}^i$$

For modules with equal nominal capacity, the capacity lost from the remaining modules Nnd is equal to:

$$\Delta SOC_{t=2}^j = -\frac{\sum_{j,j\neq i}^{N_d}\left(SOC_{end}^j - SOC_{diag\ stop}^j\right)}{N - N_d}$$

For modules with unequal nominal capacity, the equation is:

$$\Delta Capacity_{t=2}^j = -\frac{\sum_{j,j\neq i}^{N_d}\left(Capacity_{end}^j - Capacity_{diag\ stop}^j\right)}{N - N_d}$$

LIST OF REFERENCE SIGNS

1 - first electrical phase
2 - second electrical phase
3 - third electrical phase
200 - multilevel converter
204 - plurality of power converter modules
206 - grid terminal connector
208 - power grid
210 - interphase connector
212 - star point connector
214 - common star point
402 - measurement unit
2600 - plurality of energy sources
2800 - switching element
2802 - module string
2804 - module string
2806 - terminal connection

2808 - terminal connection
a - grid phase
b - grid phase
c - grid phase
N - plurality of modules
N1 - first diagnostic module
N2 - second module
N3 - third module
Nnd - other non-diagnostic modules
S1 - step "selectively switching"
S2 - step "selectively switching"
S3 - step "charging or discharging the at least one first module"
S4 - step "when the first predefined criterion is reached, discharging or charging the at least one first module"

**Claims**

1. A method for performing a diagnostic test on a multilevel converter (200) comprising a plurality of modules (N) at least one of which having a preferably predefined State of Charge (SOC), wherein the plurality of modules (N) each comprises a plurality of energy sources (2600) and a plurality of power converter modules (204), the method comprising:

    - selectively switching at least one first module (N1) of the plurality of modules (N) into series positive or into series negative with at least one second module (N2) of the plurality of modules (N);
    - connecting at least one third module (N3) of remaining modules (Nnd) of the plurality of modules (N) into series positive and/or into series negative and/or in parallel to one another;
    - charging or discharging the at least one first module (N1) from or to the at least one or more of the remaining modules (Nnd) at a first predefined charge or discharge rate until a first predefined criterion is reached;
    - when the first predefined criterion is reached, discharging or charging the at least one first module (N1) from or to the at least one or more of the remaining modules (Nnd) at a second predefined discharge or charge rate until a second predefined criterion is reached.

2. The method of claim 1, wherein the at least one first module (N1) being in a diagnostic state for performing at least one diagnostic test, when the step of charging or discharging the at least one first module (N1) from or to the at least one or more of the remaining modules (Nnd) at the first predefined charge or discharge rate until the first predefined criterion is reached.

3. The method of claim 2, wherein when the second predefined criterion is reached, switching the at least one first module (N1) from the diagnostic state to a non-diagnostic state, wherein the at least one first module (N1) is connected in parallel with the at least one or more of the remaining modules (Nnd).

4. The method of claim 2, further comprising continuing to perform the at least one diagnostic test on the at least one second module (N2), when the second predefined criterion is reached, wherein the second predefined criterion is a time available to perform the at least one diagnostic test.

5. The method of any of preceding claims, further comprising selectively switching the at least one second module (N2) of the plurality of modules (N) from a non-diagnostic state to the diagnostic state and connecting the at least one second module (N2) into series positive or into series negative with at least one fourth module (N4) of the plurality of modules (N), wherein the at least one or more of the remaining modules (Nnd) of the plurality of modules (N) are connected into series positive and/or into series negative and/or in parallel to one another.

6. The method of any of preceding claims, further comprising generating a first potential difference between the at least one first module (N1) and the at least one or more of the remaining modules (Nnd) by switching the at least one first module (N1) into series positive or series negative with respect to the at least one or more of the remaining modules (Nnd) being switched into series negative or series positive with one another, or
generating the first potential difference between the at least one first module (N1) and the at least one or more of the remaining modules (Nnd) by, preferably alternately, switching the at least one first module (N1) into series positive or into series negative with the at least one second module (N2) of the plurality of modules (N), wherein the at least one or more of the remaining modules (Nnd) are switched into series negative or into series positive or into parallel.

7. The method of claim 6, wherein a sum of potential differences between the at least one second module (N2) and the at least one or more of the remaining modules (Nnd) is higher than the first potential difference.

8. The method of any of preceding claims, further comprising measuring by at least one measurement unit (402) at least a voltage and/or a current and/or a temperature of the at least one first module (N1), when the at least one first module (N1) is charged or discharged,

wherein, the method further comprising determining by the at least one measurement unit (402) a differential capacity, dQ/dV, of the at least one first module (N1), based on at least the measured voltage of the at least one first module (N1),
or
wherein a time pulse and/or a C-Rate for charging or discharging of the at least one first module (N1) is different from a further time pulse and/or a further C-Rate for charging or discharging of the at least one second module (N2).

9. The method of any of preceding claims, wherein the multilevel converter (200) comprises at least two electrical phases (1, 2, 3), a first electric phase (1) comprising the at least one of the plurality of power converter modules (204) and/or the at least one of the plurality of energy sources (2600) and a second electric phase (2) comprising at least another one of the plurality of power converter modules (204) and/or at least another one of the plurality of energy sources (2600), wherein the method further comprising: charging or discharging the electrical energy stored in the at least one of the plurality of power converter modules (204) and/or in the at least one of the plurality of energy sources (2600) of the first phase (1) from or to the at least another one of the plurality of power converter modules (204) and/or to the at least another one of the plurality of energy sources (2600) of the second phase (2).

10. The method of any of preceding claims, further comprising controlling an effective current by a pulse width modulation controller on each of the plurality of modules (N) such that the time pulse and/or the C-Rate for charging or discharging of the at least one first module (N1) remains unchanged or varied as required by a diagnostic test, in particular, by applying a series of pulses or the like.

11. The method of any of preceding claims, wherein the first predefined criterion and the second predefined criterion are the respective State of the Charge (SOC), wherein the first and second predefined criteria are in the range from 0 to 100, preferably in the range from 10 to 90 SOC.

12. The method of any of preceding claims, further comprising rebalancing of the SOC of the plurality of modules (N), wherein the at least one first module (N1) is connected into series negative and the at least one or more of the remaining modules (Nnd) are connected into series positive and/or into series negative and/or in parallel to one another.

13. The method of any of preceding claims, wherein a minimum value of SOC of the at least one first module (N1) before charging is equal to or higher than a sum of differences between a value of 100% of SOC and an initial SOC of each of the remaining modules (Nnd) before charging of the at least one first module (N1).

14. The method of any of preceding claims, wherein a minimum value of SOC of the at least one first module (N1) before discharging is equal to or higher than an initial SOC of the at least one first module (N1), where the initial SOC is a value of SOC before starting the diagnostic test.

15. The method of claim 12, wherein the rebalancing of the SOC of the plurality of modules (N) comprises charging or discharging the at least one first module (N1) to a first final SOC, wherein the first final SOC is a difference between a maximum SOC and a minimum SOC divided by a number of the remaining modules (Nnd).

Fig. 1

Fig. 2

Fig. 3

Europäisches
Patentamt

European
Patent Office

Office européen
des brevets

# EUROPEAN SEARCH REPORT

**Application Number**

EP 23 21 7308

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2019 120947 B3 (PORSCHE AG [DE]) 12 November 2020 (2020-11-12) | 1-6,9-15 | INV. H02M7/483 H02M1/32 |
| Y | * paragraphs [0007], [0010], [0017], | 7 | |
| A | [0021], [0033], [0034], [0041]; figure 1 * | 8 | |
| Y | US 2014/203778 A1 (OHNUKI YASUMICHI [JP]) 24 July 2014 (2014-07-24) * paragraphs [0089], [0091], [0092]; figures 4-13 * | 7 | |
| A | US 2017/170658 A1 (TENGNER TOMAS [SE] ET AL) 15 June 2017 (2017-06-15) * figure 1 * | 1-15 | |
| A | CN 104 917 224 A (UNIV SOUTH CHINA TECH) 16 September 2015 (2015-09-16) * abstract; figures 4,5 * | 1-15 | |

| | | | TECHNICAL FIELDS SEARCHED (IPC) |
|---|---|---|---|
| | | | H02M |

The present search report has been drawn up for all claims

| Place of search | Date of completion of the search | Examiner |
|---|---|---|
| The Hague | 21 May 2024 | Kanelis, Konstantin |

EPO FORM 1503 03.82 (P04C01)

**EP 4 572 121 A1**

## ANNEX TO THE EUROPEAN SEARCH REPORT
## ON EUROPEAN PATENT APPLICATION NO.

EP 23 21 7308

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2024

| Patent document cited in search report | Publication date | Patent family member(s) | | Publication date |
|---|---|---|---|---|
| DE 102019120947 B3 | 12-11-2020 | NONE | | |
| US 2014203778 A1 | 24-07-2014 | CN | 103733471 A | 16-04-2014 |
| | | JP | 5624678 B2 | 12-11-2014 |
| | | JP | WO2013031412 A1 | 23-03-2015 |
| | | US | 2014203778 A1 | 24-07-2014 |
| | | WO | 2013031412 A1 | 07-03-2013 |
| US 2017170658 A1 | 15-06-2017 | CN | 106030955 A | 12-10-2016 |
| | | EP | 3108560 A1 | 28-12-2016 |
| | | US | 2017170658 A1 | 15-06-2017 |
| | | WO | 2015124176 A1 | 27-08-2015 |
| CN 104917224 A | 16-09-2015 | NONE | | |

EPO FORM P0459

For more details about this annex : see Official Journal of the European Patent Office, No. 12/82